# EUROPEAN PATENT APPLICATION

(11) **EP 4 715 409 A1**
(43) Date of publication of application: **25.03.2026**
(21) Application number: 24845800.2
(22) Date of filing: 12.06.2024
(51) Int. Cl.: G01R 31/392, G01R 31/396, G01R 31/367, G01R 29/02, G01R 29/027, G01R 23/00, G01R 23/15

(54) **BATTERY DIAGNOSIS APPARATUS, BATTERY DIAGNOSIS METHOD, AND BATTERY DIAGNOSIS SYSTEM**

(30) Priority: 25.07.2023 KR 20230096958
(71) Applicant: LG Energy Solution, Ltd., Seoul 07335 (KR)
(72) Inventor: JEON, Young Hwan, Daejeon 34122 (KR)
(74) Representative: Plasseraud IP
(86) International application number: PCT/KR2024/008073
(87) International publication number: WO 2025/023496

(57) **Abstract**

According to some embodiments disclosed herein, a battery diagnosis apparatus includes a sensor configured to measure time-based first battery data from a diagnosis target battery and a controller configured to pre-process the first battery data to generate pre-processed data, generate frequency-based second battery data based on the pre-processed data, and diagnose, based on statistical data related to the second battery data, whether the diagnosis target battery is abnormal.

## Description

### TECHNICAL FIELD

### CROSS-REFERENCE TO RELATED APPLICATION

This application claims priority to and the benefit of Korean Patent Application No. 10-2023-0096958 filed in the Korean Intellectual Property Office on July 25, 2023, the entire content of which is incorporated herein by reference.

### TECHNICAL FIELD

Embodiments disclosed herein relate to a battery diagnosis apparatus, a battery diagnosis method, and a battery diagnosis system.

### BACKGROUND ART

Recently, research and development of secondary batteries have been actively performed. Herein, the secondary batteries, which are chargeable/dischargeable batteries, may be interpreted as including all of conventional nickel (Ni)/cadmium (Cd) batteries, Ni/metal hydride (MH) batteries, etc., and recent lithium-ion batteries. Among secondary batteries, lithium-ion batteries may have a higher energy density than conventional Ni/Cd batteries, Ni/MH batteries, etc., and may be manufactured to be small and lightweight, allowing them to have high usability in terms of power sources for mobile devices. Recently, the lithium ion battery is attracting attention as a next-generation energy storage medium as a usage range thereof is expanded to a power source of electric vehicles.

Diagnosis of whether a battery is abnormal may be performed based on signals measured in a time domain. For example, changes in voltage, current, or temperature over time may be measured from the battery, and based on them, presence of an error or a defect in the battery may be diagnosed. However, time-based signals may include various noise and measurement errors, and for analysis of a long-term pattern, a part of data may be lost due to application of a filter.

### DISCLOSURE

### TECHNICAL PROBLEM

Embodiments disclosed herein aim to provide a battery diagnosis apparatus, a battery diagnosis method, and a battery diagnosis system, which are capable of diagnosing a battery from other aspects to solve problems of battery diagnosis based on a time domain.

Technical problems of the embodiments disclosed herein are not limited to the above-described technical problems, and other unmentioned technical problems would be clearly understood by one of ordinary skill in the art from the following description.

### TECHNICAL SOLUTION

According to some embodiments disclosed herein, a battery diagnosis apparatus includes a sensor configured to measure time-based first battery data from a diagnosis target battery and a controller configured to pre-process the first battery data to generate pre-processed data, generate frequency-based second battery data based on the pre-processed data, and diagnose, based on statistical data related to the second battery data, whether the diagnosis target battery is abnormal.

According to some embodiments, the controller may be further configured to calculate statistical values for amplitude values of the second battery data corresponding to battery cells of the diagnosis target battery and frequency values of the second battery data and diagnose, based on the statistical values, whether the diagnosis target battery is abnormal.

According to some embodiments, the controller may be further configured to calculate error values of the amplitude values based on the statistical values and diagnose, based on a number of error values exceeding an error reference value among the error values, whether the diagnosis target battery is abnormal.

According to some embodiments, the controller may be further configured to calculate a median value of the amplitude values for each of the frequency values to calculate median values corresponding to the frequency values and calculate the error values of the amplitude values based on the median value.

According to some embodiments, the controller may be further configured to calculate an average and a variance of the error values for each battery cell and diagnose, based on the average and the variance of the error values, whether each battery cell is abnormal.

According to some embodiments, the controller may be further configured to count a number of frequency values having an error value exceeding an error reference value, among the frequency values, for each battery cell, and determine, as an abnormal battery cell, a battery cell in which the number of frequency values having the error value exceeding the error reference value exceeds a number reference value, among the battery cells.

According to some embodiments, the controller may be further configured to determine the abnormal battery cell for each test cycle to count a number of abnormal battery cells and determine, as an abnormal battery, the diagnosis target battery when the number of abnormal battery cells exceeds an abnormal battery cell reference value upon completion of a preset number of test cycles.

According to some embodiments, the controller may be further configured to perform time aggregation pre-processing on the first battery data to generate temporal uniform data and perform missing value imputation pre-processing on the temporal uniform data to generate the pre-processed data.

According to some embodiments disclosed herein, a battery diagnosis method includes measuring time-based first battery data from a diagnosis target battery, pre-processing the first battery data to generate pre-processed data, generating frequency-based second battery data based on the pre-processed data, and diagnosing, based on statistical data related to the second battery data, whether the diagnosis target battery is abnormal.

According to some embodiments, the diagnosing of whether the diagnosis target battery is abnormal may include calculating statistical values for amplitude values of the second battery data corresponding to battery cells of the diagnosis target battery and frequency values of the second battery data and diagnosing, based on the statistical values, whether the diagnosis target battery is abnormal.

According to some embodiments, the diagnosing of whether the diagnosis target battery is abnormal may include calculating error values of the amplitude values based on the statistical values and diagnosing, based on a number of error values exceeding an error reference value among the error values, whether the diagnosis target battery is abnormal.

According to some embodiments, the calculating of the error values may include calculating a median value of the amplitude values for each of the frequency values to calculate median values corresponding to the frequency values and calculating the error values of the amplitude values based on the median value.

According to some embodiments, the diagnosing of whether the diagnosis target battery is abnormal may include calculating an average and a variance of the error values for each battery cell and diagnosing, based on the average and the variance of the error values, whether each battery cell is abnormal.

According to some embodiments, the diagnosing of whether the diagnosis target battery is abnormal may include counting a number of frequency values having an error value exceeding an error reference value, among the frequency values, for each battery cell and determining, as an abnormal battery cell, a battery cell in which the number of frequency values having the error value exceeding the error reference value exceeds a number reference value, among the battery cells.

According to some embodiments, the diagnosing of whether the diagnosis target battery is abnormal may include determining the abnormal battery cell for each test cycle to count a number of abnormal battery cells and determining, as an abnormal battery, the diagnosis target battery when the number of abnormal battery cells exceeds an abnormal battery cell reference value upon completion of a preset number of test cycles.

According to some embodiments, the generating of the pre-processed data may include performing time aggregation pre-processing on the first battery data to generate temporal uniform data and performing missing value imputation pre-processing on the temporal uniform data to generate the pre-processed data.

According to some embodiments disclosed herein, a battery diagnosis system includes a diagnosis target battery, a charger/discharger configured to apply test cycle voltage to the diagnosis target battery, a battery diagnosis apparatus configured to measure time-based first battery data from the diagnosis target battery, pre-process the first battery data to generate pre-processed data, generate frequency-based second battery data based on the pre-processed data, and diagnose, based on statistical data related to the second battery data, whether the diagnosis target battery is abnormal, and a management server configured to manage a diagnosis result for the diagnosis target battery.

According to some embodiments, the battery diagnosis apparatus may be further configured to calculate statistical values for amplitude values of the second battery data corresponding to battery cells of the diagnosis target battery and frequency values of the second battery data and diagnose, based on the statistical values, whether the diagnosis target battery is abnormal.

According to some embodiments, the battery diagnosis apparatus may be further configured to calculate error values of the amplitude values based on the statistical values and diagnose, based on a number of error values exceeding an error reference value among the error values, whether the diagnosis target battery is abnormal.

According to some embodiments, the battery diagnosis apparatus may be further configured to calculate a median value of the amplitude values for each of the frequency values to calculate median values corresponding to the frequency values and calculate the error values of the amplitude values based on the median value.

According to some embodiments, the battery diagnosis apparatus may be further configured to calculate an average and a variance of the error values for each battery cell and diagnose, based on the average and the variance of the error values, whether each battery cell is abnormal.

According to some embodiments, the battery diagnosis apparatus may be further configured to count a number of frequency values having an error value exceeding an error reference value, among the frequency values, for each battery cell, and determine, as an abnormal battery cell a battery cell in which the number of frequency values having the error value exceeding the error reference value exceeds a number reference value, among the battery cells..

According to some embodiments, the battery diagnosis apparatus may be further configured to determine the abnormal battery cell for each test cycle to count a number of abnormal battery cells and determine, as an abnormal battery, the diagnosis target battery when the number of abnormal battery cells exceeds an abnormal battery cell reference value upon completion of a preset number of test cycles.

According to some embodiments, the battery diagnosis apparatus may be further configured to perform time aggregation pre-processing on the first battery data to generate temporal uniform data and perform missing value imputation pre-processing on the temporal uniform data to generate the pre-processed data.

### ADVANTAGEOUS EFFECTS

According to embodiments disclosed herein, there may be provided a battery diagnosis apparatus, a battery diagnosis method, and a battery diagnosis system, which are capable of diagnosing a battery from other aspects to solve problems of battery diagnosis based on a time domain.

The technical effects according to embodiments disclosed in the present document are not limited to the effects mentioned above, and other effects not mentioned will be clearly understood by those of ordinary skill in the art according to the disclosure of the present document.

### DESCRIPTION OF DRAWINGS

FIG. 1 illustrates components of a battery diagnosis system according to some embodiments.
FIG. 2 illustrates components of a battery diagnosis apparatus and operations of the battery diagnosis apparatus, according to some embodiments.
FIG. 3 illustrates a detailed operating process of a battery diagnosis apparatus according to some embodiments.
FIG. 4 illustrates a process of generating pre-processed data by performing pre-processing on first battery data, according to some embodiments.
FIG. 5 illustrates a process of generating frequency-based second battery data by performing domain conversion on pre-processed data, according to some embodiments.
FIG. 6 illustrates amplitude values A₁₁, ..., Aₙₘ for battery cells C1, ..., Cn and frequency values f1, ..., fm, according to some embodiments.
FIG. 7 illustrates a process of calculating a median value Mj of amplitude values Alj, ..., Anj for each frequency value fj, according to some embodiments.
FIG. 8 illustrates a process of calculating error values E1j, ..., Enj of the amplitude values A1j, ..., Anj based on the median value Mj, according to some embodiments.
FIG. 9 illustrates a process of calculating an error reference value (xi1 + 4 * xi2) for each battery cell ci, according to some embodiments.
FIG. 10 illustrates a process of sorting a battery cell having a greater number of frequency values exceeding the error reference value than a number reference value from among the battery cells c1, ..., cn, according to some embodiments.
FIG. 11 illustrates a process of determining an abnormal battery cell for each test cycle to count the number of abnormal cells, according to some embodiments.
FIG. 12 illustrates a process of determining whether a diagnosis target battery is abnormal, based on the number of abnormal cells, when a preset number of test cycles are completed, according to some embodiments.
FIG. 13 illustrates operations of a battery diagnosis method according to some embodiments.

### MODE FOR INVENTION

Hereinafter, embodiments disclosed herein will be described with reference to the accompanying drawings. However, the description is not intended to limit the disclosure of the present document to particular embodiments, and it should be construed as including various modifications, equivalents, and/or alternatives according to the embodiments described herein.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

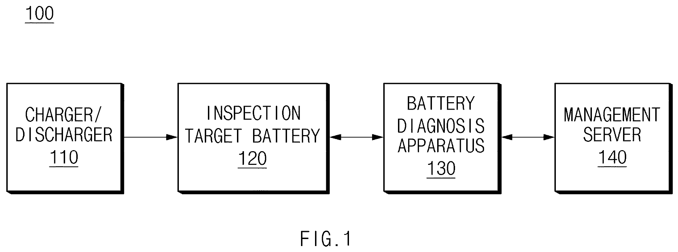

FIG. 1 illustrates components of a battery diagnosis system according to some embodiments.

Referring to FIG. 1, a battery diagnosis system 100 may include a charger/discharger 110, an inspection target battery 120, a battery diagnosis apparatus 130, and a management server 140. However, without being limited thereto, some components may be omitted from the battery diagnosis system 100 or other general-purpose components may be further included in the battery diagnosis system 100.

The battery diagnosis system 100 may refer to a system for diagnosing a state of the inspection target battery 120. According to an embodiment, a test voltage may be applied to the inspection target battery 120 by the charger/discharger 110, and a signal in the time domain, output by the inspection target battery 120 in response to the test voltage, may be measured by the battery diagnosis apparatus 130. The signal in the time domain may be converted into data in the frequency domain, and it may be determined, based on data in a frequency domain, whether the inspection target battery 120 is abnormal.

According to an embodiment, the charger/discharger 110 may be configured to apply a test cycle voltage to the diagnosis target battery 120. The test cycle voltage may have a profile for charging and discharging the diagnosis target battery 120, and may be applied to the diagnosis target battery 120 a plurality of times. The number of times of repeated application of the test cycle voltage may be set to 50, 100, 200, or other appropriate values. For example, the charger/discharger 110 may include a power supply device for applying various types of voltage or current to the diagnosis target battery 120.

According to an embodiment, the diagnosis target battery 120 may be a diagnosis target of the battery diagnosis system 100. The diagnosis target battery 120 may include a plurality of battery cells. For example, the diagnosis target battery 120 may include a plurality of battery modules, and each of the plurality of battery modules may include a plurality of battery cells. According to an embodiment, when the number of battery cells having an error is greater than or equal to a specific number in each of the plurality of test cycles, a corresponding cycle may be counted as a cycle having an error, and when the number of counts of cycles having an error is greater than or equal to a specific value upon completion of the plurality of test cycles, it may be finally determined that the diagnosis target battery 120 is abnormal.

The battery diagnosis apparatus 130 may perform procedures for determining whether the diagnosis target battery 120 is abnormal. According to an embodiment, the battery diagnosis apparatus 130 may convert data in the time domain into data in the frequency domain and perform additional processing on the data in the frequency domain to determine abnormality.

According to an embodiment, the management server 140 may be configured to manage a diagnosis result for the diagnosis target battery 120. The management server 140 may be connected to the battery diagnosis apparatus 130 through wired/wireless data communication, and may be provided with data such as the state, abnormality, and diagnosis result of the diagnosis target battery 120 from the battery diagnosis apparatus 130 and record the data. The management server 140 may control the battery diagnosis apparatus 130 or manage the diagnosis target battery 120 at the request of a system manager or a battery user.

According to an embodiment, the management server 140 may perform at least some of procedures performed by the battery diagnosis apparatus 130 on behalf of the battery diagnosis apparatus 130. The management server 140 may receive data necessary for diagnosing the diagnosis target battery 120 from the battery diagnosis apparatus 130, perform diagnosis procedures, and transmit a result to the battery diagnosis apparatus 130. According to an embodiment, the management server 140 may install energy management software necessary for diagnosing the diagnosis target battery 120 on the battery diagnosis apparatus 130 and provide update information of the energy management software to the battery diagnosis apparatus 130.

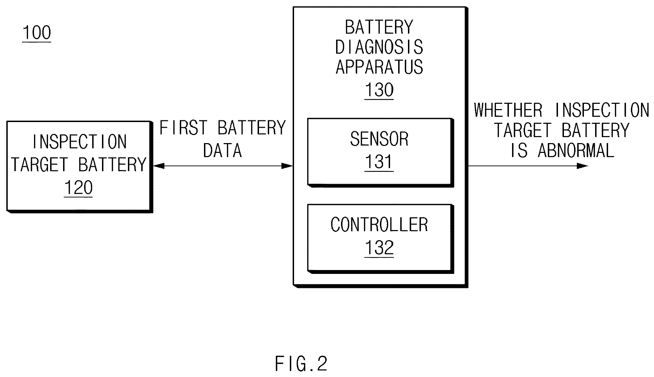

FIG. 2 illustrates components of a battery diagnosis apparatus and operations of the battery diagnosis apparatus, according to some embodiments.

Referring to FIG. 2, the battery diagnosis apparatus 130 may include a sensor 131 and a controller 132. However, without being limited thereto, some components may be omitted from the battery diagnosis apparatus 130 or other general-purpose components may be further included in the battery diagnosis apparatus 130.

According to an embodiment, in the battery diagnosis apparatus 130, the sensor 131 and the controller 132 may be electrically connected to each other through communication between devices such as a bus, general purpose input and output (GPIO), serial peripheral interface (SPI), mobile industry processor interface (MIPI), etc.

The sensor 131 of the battery diagnosis apparatus 130 may be configured to measure first battery data based on time from the diagnosis target battery 120. When a test cycle voltage is applied to the diagnosis target battery 120 by the charger/discharger 110, an output voltage may be generated in the diagnosis target battery 120 in response thereto, and the sensor 131 may measure the output voltage to generate the first battery data. To this end, the sensor 131 may include measuring means such as a voltmeter, an ammeter, a thermometer, etc. According to an embodiment, the first battery data may include a signal in a time domain. For example, the first battery data may include voltage data, current data, and/or temperature data in the time domain.

The controller 132 may have a structure for executing instructions that implement the operations of the battery diagnosis apparatus 130. The controller 132 may be implemented with an array of multiple logic gates or a general-purpose microprocessor for processing various operations, and may include a single processor or a plurality of processors. For example, the controller 132 may be implemented in the form of at least one of a microprocessor, a CPU, a GPU, and an AP.

The controller 132 may be configured separately from or integrally with a memory (not shown) configured to store instructions, and may process various operations by executing the instructions stored in the memory. The memory may store various data, instructions, mobile applications, computer programs, etc. For example, the memory may be implemented in the form of non-volatile memory such as ROM, PROM, EPROM, EEPROM, flash memory, PRAM, MRAM, FRAM, etc., or volatile memory such as DRAM, SRAM, SDRAM, RRAM, HDD, SSD, SD, Micro-SD, etc., or may be implemented in the form of a combination thereof.

The controller 132 of the battery diagnosis apparatus 130 may be configured to pre-process the first battery data and generate the pre-processed data. Pre-processing performed on the first battery data may include a preparation process for converting the first battery data in the time domain into second battery data in the frequency domain. For example, pre-processing may include equalization of data with respect to time and/or processing to fill in missing values.

The controller 132 of the battery diagnosis apparatus 130 may be configured to generate the second battery data based on frequency, on the basis of the pre-processed data. To generate the second battery data, domain conversion performed on the pre-processed data may mean converting a signal/data in the time domain into a signal/data in the frequency domain. According to an embodiment, the domain conversion may include fast Fourier transform (FFT). The second battery data may include amplitude values changing with frequency values which may be continuous or discrete values.

The controller 132 of the battery diagnosis apparatus 130 may be configured to diagnose whether the diagnosis target battery 120 is abnormal, based on statistical data associated with the second battery data. The second battery data may indicate amplitude values of battery cells of the diagnosis target battery 120 in a given range of frequency values, and it may be determined whether the diagnosis target battery 120 is abnormal, by using statistical variables based on the amplitude values. According to an embodiment, the statistical data associated with the second battery data may include an average, a median value, a first quartile, a third quartile, a variance, a standard deviation, etc., for values of the second battery data.

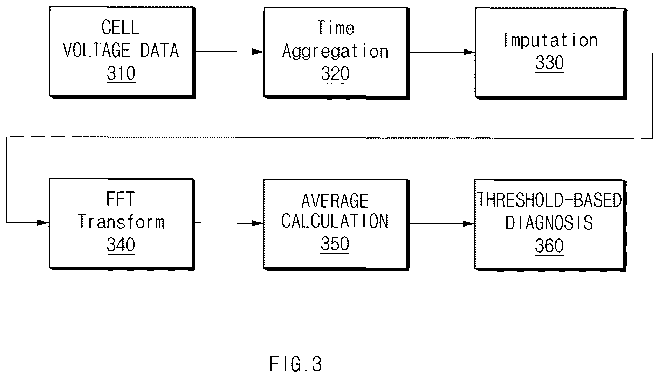

FIG. 3 illustrates a detailed operating process of a battery diagnosis apparatus according to some embodiments.

Referring to FIG. 3, a detailed operating process of the battery diagnosis apparatus 130 may include a first operation 310 for data measurement, a second operation 320 for time aggregation, a third operation 330 for missing value imputation, a fourth operation 340 for domain conversion, a fifth operation 350 for statistical value calculation, and a sixth operation 360 for abnormality diagnosis.

Unlike an existing diagnosis scheme using a time-based signal, the first operation 310 through the sixth operation 360 may diagnose whether the diagnosis target battery 120 is abnormal, by using frequency-based data. In the existing time-based scheme, a method of detecting an instant difference of a signal has been used, but in the frequency-based scheme according to the first operation 310 to the sixth operation 360, a frequency component of a signal hidden by noise may be detected, based on which a cell having a pattern out of a normal range may be detected. For example, considering that battery cells have similar characteristics, an abnormal cell may have a frequency pattern that is different from patterns of other cells. Thus, by defining the normal range based on the statistical values, continuous occurrence of the abnormal pattern even after noise cancellation may be detected.

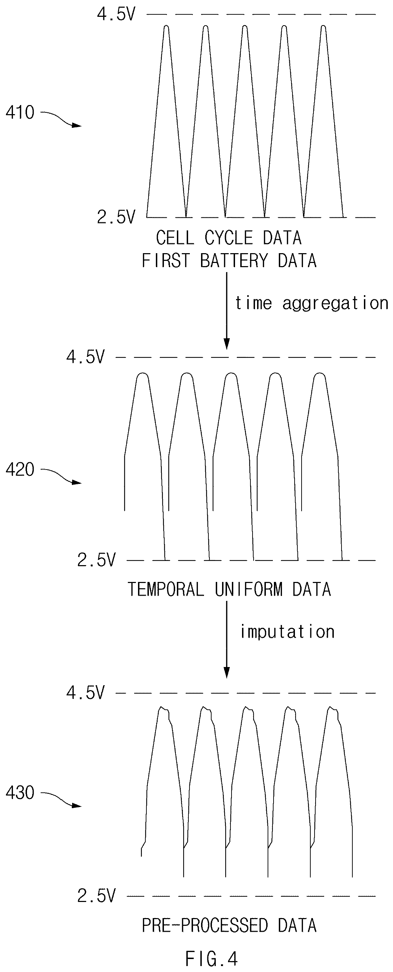

FIG. 4 illustrates a process of generating pre-processed data by performing pre-processing on first battery data, according to some embodiments.

Referring to FIG. 4, a first graph 410 indicating a waveform of the first battery measured in the time domain, a second graph 420 indicating a waveform of temporal uniform data generated as a result of time aggregation pre-processing on the first battery data, and a third graph 430 indicating a waveform of pre-processed data generated as a result of missing value imputation pre-processing on the temporal uniform data may be shown.

The first graph 410, the second graph 420, and the third graph 430 all may indicate a voltage along a vertical axis with respect to time along a horizontal axis, such that the first battery data, the temporal uniform data, and the pre-processed data all may be data in the time domain. The first battery data, the temporal uniform data, and the pre-processed data all may have periodicity, in which one period may correspond to one test cycle.

According to an embodiment, the controller 132 of the battery diagnosis apparatus 130 may be configured to perform time aggregation pre-processing on the first battery data to generate the temporal uniform data and perform missing value imputation pre-processing on the temporal uniform data to generate the pre-processed data. According to the time aggregation pre-processing, values of the first battery data may be uniformly adjusted for time, and as a result, the temporal uniform data may be generated. According to the missing value imputation pre-processing, when there is a measurement missing value in the temporal uniform data based on a given time step, the missing value may be supplemented through polarization.

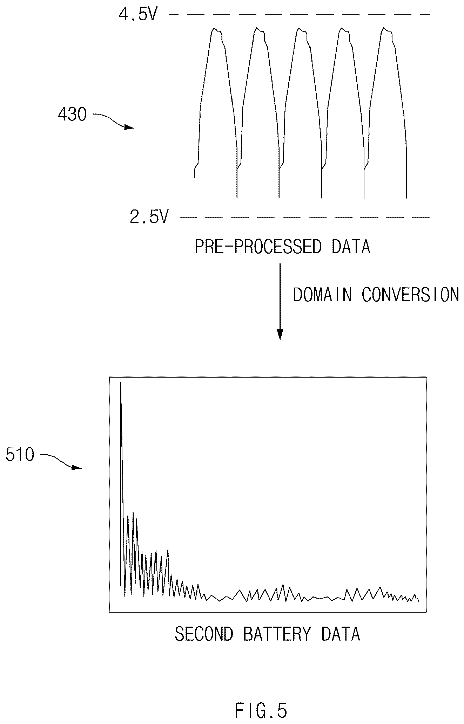

FIG. 5 illustrates a process of generating frequency-based second battery data by performing domain conversion on pre-processed data, according to some embodiments.

Referring to FIG. 5, the third graph 430 indicating the waveform of the pre-processed data and a fourth graph 510 indicating the second battery data in the frequency domain, generated as a result of domain conversion on the pre-processed data, may be shown. The fourth graph 510 may show an amplitude value along the vertical axis with respect to a frequency along the horizontal axis.

When domain conversion is performed on the time-based pre-processed data shown in the third graph 430, the frequency-based second battery data shown in the fourth graph 510 may be generated. According to an embodiment, the domain conversion performed on the pre-processed data to generate the second battery data may include fast Fourier transform (FFT) or time-frequency conversion of other various types.

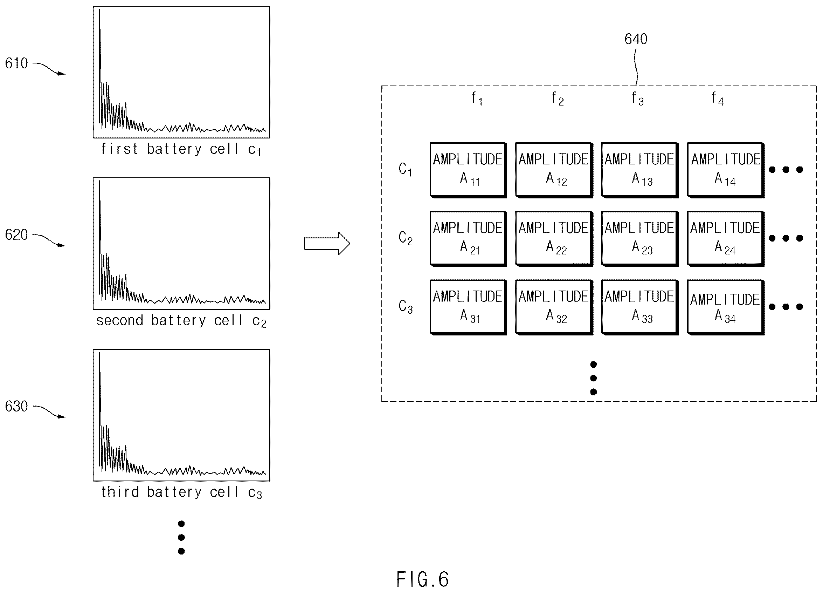

FIG. 6 illustrates amplitude values A₁₁, ..., Aₙₘ for battery cells C1, ..., Cn and frequency values f1, ..., fm, according to some embodiments.

Referring to FIG. 6, first through third graphs 610, 620, and 630 indicating frequency-based second battery data, respectively generated for a first battery cell c1, a second battery cell c2, and a third battery cell c3 of the diagnosis target battery 120, may be shown.

The second battery data shown in the first to third graphs 610, 620, and 630 may be reconfigured like an amplitude diagram 640 for the battery cells c1, ..., cn of the diagnosis target battery 120 and the frequency values f1, ..., fm of the second battery data. When the diagnosis target battery 120 includes n battery cells c1, ..., cn and the second battery data includes m frequency values f1, ..., fm, each battery cell ci may have amplitude values Ai1, ..., Aim for the m frequency values f1, ..., fm.

According to an embodiment, the controller 132 of the battery diagnosis apparatus 130 may be configured to calculate statistical values for the amplitude values A₁₁, ..., Aₙₘ of the second battery data corresponding to the battery cells c1, ..., cn of the diagnosis target battery 120 and the frequency values f1, ..., fm of the second battery data and diagnose abnormality based on the statistical values. The statistical values for the amplitude values A₁₁, ...Aₙₘ may be derived in various manners. According to an embodiment, in the amplitude diagram 640, statistical values may be calculated for the same frequency value in the vertical direction and all battery cells, or statistical values may be calculated for the same battery cell in the horizontal direction and all frequency values.

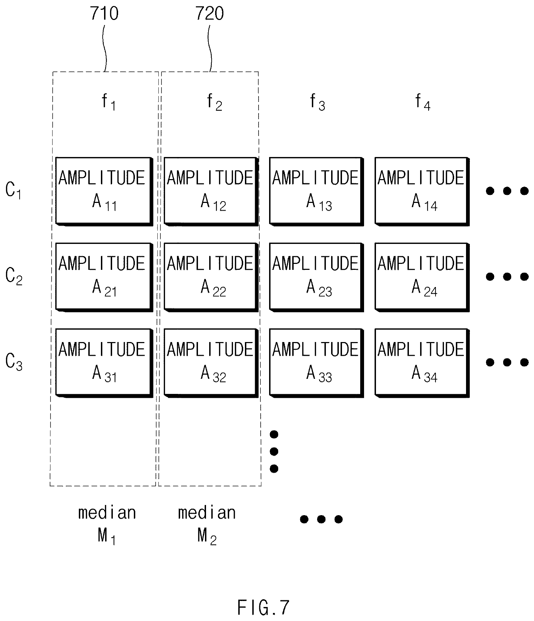

FIG. 7 illustrates a process of calculating a median value Mj of amplitude values A1j, ..., Anj for each frequency value fj, according to some embodiments.

Referring to FIG. 7, as an example where statistical values are calculated for the same frequency value in the vertical direction and all battery cells in the amplitude diagram, first statistical value calculation 710 for a first frequency f1 and all the battery cells c1, ..., cn and second statistical value calculation 720 for a second frequency f2 and all the battery cells c1, ..., cn may be shown.

For the first statistical value calculation 710, statistical values for an amplitude A₁₁ of the first battery cell c1 at the first frequency f1, an amplitude A₂₁ of the second battery cell c2 at the first frequency f1, an amplitude A₃₁ of the third battery cell c3 at the first frequency f1, etc., may be calculated, in which the statistical values may be median values. According to an embodiment, the statistical values may further include an average value, a first quartile, a third quartile, a variance, a standard deviation, etc. The statistical values for all the frequency values f1, ..., fm may be calculated in the same manner as the first frequency f1.

According to an embodiment, the controller 132 of the battery diagnosis apparatus 130 may be configured to calculate a median value Mj of the amplitude values A1j, ..., Anj for each frequency value fj of the frequency values to calculate median values M₁, ..., Mm corresponding to the frequency values f1, ..., fm, and calculate error values E1j, ..., Enj of the amplitude values A1j, ..., Anj based on the median value Mj. According to an embodiment, other types of representative values such as an average value, a first quartile, a third quartile, a variance, a standard deviation, etc., may be used in place of the median value Mj.

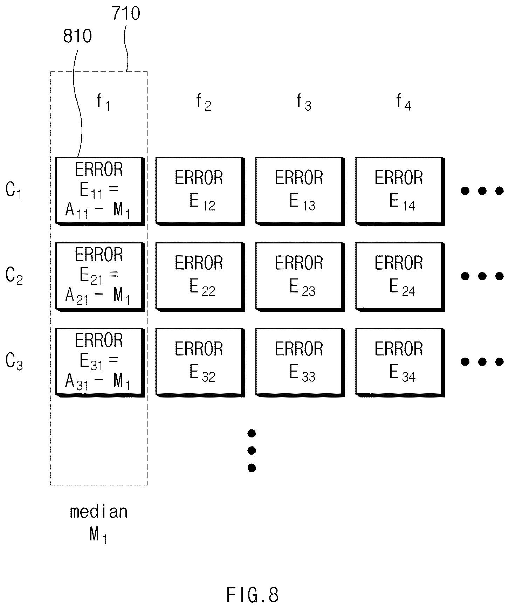

FIG. 8 illustrates a process of calculating the error values E1j, ..., Enj of the amplitude values A1j, ..., Anj based on the median value Mj, according to some embodiments.

Referring to FIG. 8, a process of calculating error values of amplitude values of battery cells for one frequency value in an amplitude diagram may be shown in relation to error calculation 810 of the first statistical value calculation 710.

In the error calculation 810, the first median value M₁ calculated for the first frequency f1 may be used for calculation of an error of the amplitude value A₁₁, and may be identically for calculation of errors of the other amplitude values A₂₁, A₃₁, .... Meanwhile, other types of representative values as well as the median value may be used for error calculation. According to an embodiment, an average value, a first quartile, a third quartile, a variance, a standard deviation, etc., may be used as representative values for error calculation. According to an embodiment, a difference between a median value and a variance value may be expressed as an error value for each frequency.

According to an embodiment, the controller 132 of the battery diagnosis apparatus 130 may be configured to calculate error values of amplitude values based on statistical values and diagnose abnormality based on the number of error values exceeding an error reference value among the error values. When all the error values are calculated as in the error calculation 810, the number of frequencies exceeding the error reference value in each battery cell may be analyzed. For example, for the first battery cell c1, the number of frequency values having error values exceeding the error reference value among 100 frequency values f1 to f100 may be counted and when a count value exceeds a number reference value (e.g., 10), then the first battery cell c1 may be classified as an abnormal cell.

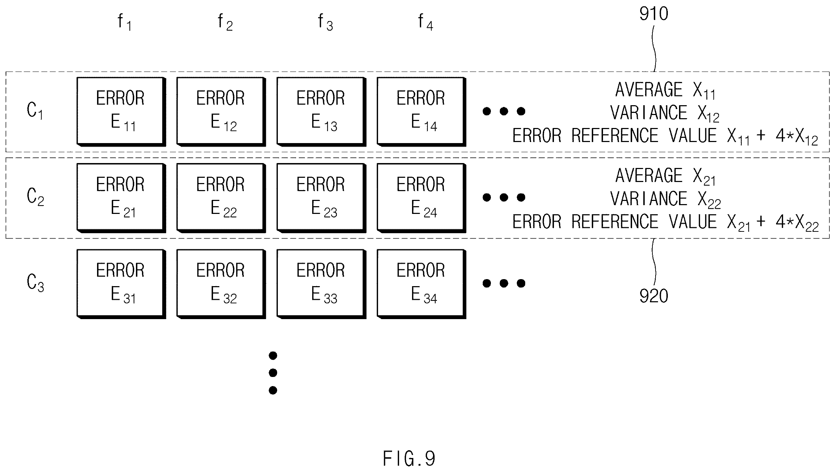

FIG. 9 illustrates a process of calculating an error reference value (xi1 + 4 * xi2) for each battery cell ci, according to some embodiments.

Referring to FIG. 9, an average x₁₁ and a variance x₁₂ of error values E₁₁, E₁₂, E₁₃, ... may be calculated in a first battery cell 910, and an error reference value for the first battery cell 910 may be calculated based on the average x₁₁ and the variance x₁₂. In the same manner, error reference values may be calculated for the second battery cell 920 and the other battery cells.

According to an embodiment, the controller 132 of the battery diagnosis apparatus 130 may be configured to calculate an average xi1 and a variance xi2 of error values Ei1, ..., Eim for each battery cell ci, and diagnose whether each battery cell ci is abnormal based on the average xi1 and the variance xi2 of the error values Eil, ..., Eim. According to an embodiment, other values such as a median value, a first quartile, a third quartile, a variance, a standard deviation, etc., as well as an average and a variance may be used for calculation of an error reference value.

According to an embodiment, the controller 132 of the battery diagnosis apparatus 130 may be configured to count the number of frequency values fj having the error value Eij exceeding an error reference value (xi1 + 4 * xi2) among the frequency values f1, ..., fm for each battery cell ci, and determine, as an abnormal battery cell, a battery cell in which the number of frequency values exceeding the error reference value exceeds the number reference value, among the battery cells c1, ..., cn. According to an embodiment, counts 1 and 4 of the error reference value (xi1 + 4*xi2) may be changed into other appropriate values if necessary.

The number reference value may be a preset value according to diagnosis performance requirement values of the battery diagnosis apparatus 130, and as the number of reference values decreases, diagnosis performance may increase. For example, when the number reference value is set to 10 and an error value exceeds the error reference value for 12 frequency values among 100 frequency values f1 to f100, the first battery cell c1 may be classified as a defective cell.

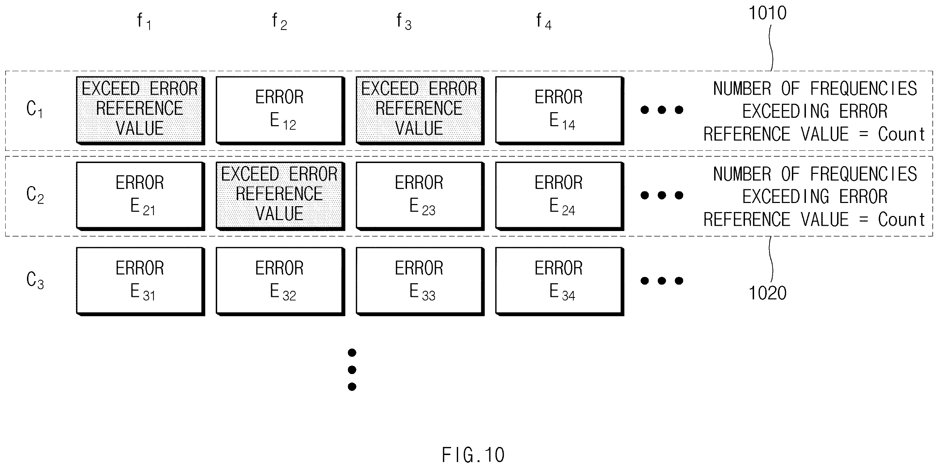

FIG. 10 illustrates a process of sorting a battery cell having a greater number of frequency values exceeding the error reference value than a number reference value from among the battery cells c1, ..., cn, according to some embodiments.

Referring to FIG. 10, the number (e.g., 2) of frequencies having errors exceeding the error reference value in a first battery cell 1010 exceeds the number reference value (e.g., 1), the first battery cell 1010 may be classified as a defective cell.

Similarly, the number (e.g., 1) of frequencies having errors exceeding the error reference value in a second battery cell 1020 does not exceed the number reference value (e.g., 1), the second battery cell 1020 may be classified as a normal cell, and the other battery cells may also be classified as defective or normal. Thus, upon completion of one test cycle, the number of battery cells classified as defective among battery cells of the diagnosis target battery 120 may be derived.

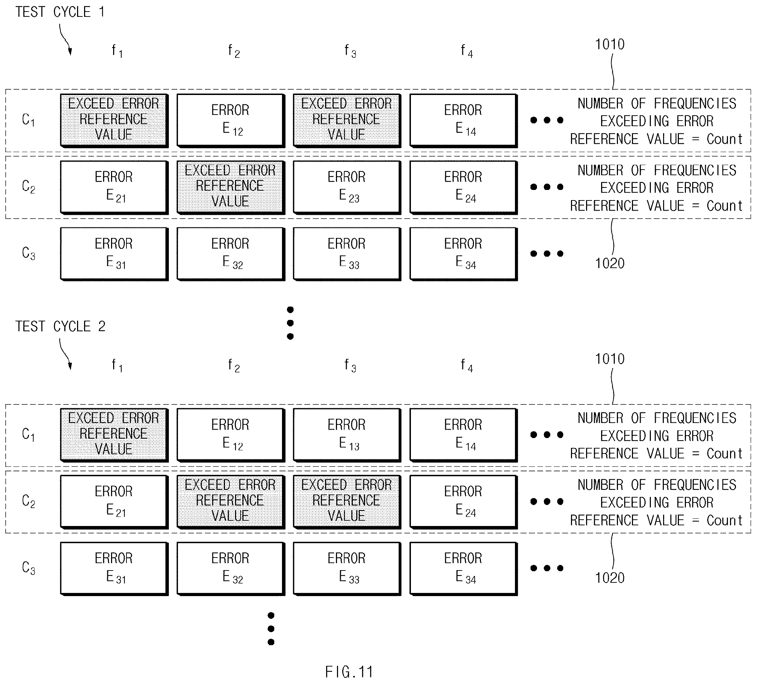

FIG. 11 illustrates a process of determining an abnormal battery cell for each test cycle to count the number of abnormal cells, according to some embodiments.

Referring to FIG. 11, the above-described process of counting the number of abnormal battery cells for each test cycle may be repeatedly performed for a plurality of test cycles.

For example, the number of battery cells classified as defective may be 3 in a test cycle 1, the number of battery cells classified as defective may be 2 in a test cycle 2, and the number of battery cells classified as defective in the other test cycles may be 0. In this case, an accumulative count value of 5 may be compared with a reference value to finally determine whether the diagnosis target battery 120 is defective. According to an embodiment, a total number of test cycles may be 100 and the reference value to be compared with the accumulative count value may be 3. However, according to a change of the diagnosis performance requirement values, other appropriate values may be used. According to an embodiment, when high diagnosis performance is required, the total number of test cycles may increase and the reference value to be compared may decrease.

According to an embodiment, the controller 132 of the battery diagnosis apparatus 130 may be configured to count the number of abnormal battery cells by determining the abnormal battery cells for each test cycle and determine that the diagnosis target battery 120 is an abnormal battery when the number of abnormal battery cells exceeds an abnormal battery cell reference value upon completion of a preset number of test cycles. For example, when a count value of the number of abnormal battery cells exceeds 3 upon completion of 100 test cycles, the diagnosis target battery 120 may be finally diagnosed as abnormal.

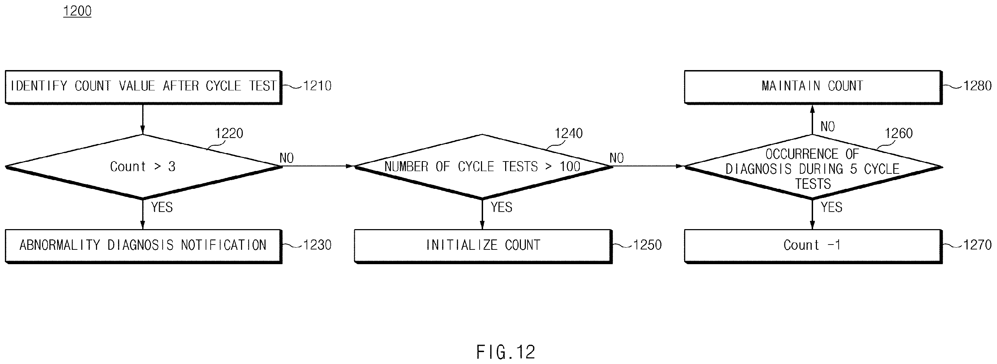

FIG. 12 illustrates a process of determining whether a diagnosis target battery is abnormal, based on the number of abnormal cells, when a preset number of test cycles are completed, according to some embodiments.

Referring to FIG. 12, a flowchart 1200 is shown to describe a change of a count value indicating the number of battery cells classified as defective while a preset number of test cycles are performed.

A count value may be identified in first operation 1210, and the count value may be compared with a reference value in second operation 1220. When the count value exceeds the reference value, a notification indicating that the diagnosis target battery 120 is abnormal may be generated in third operation 1230. When the count value does not exceed the reference value, it may be determined whether a preset number of test cycles are completed in fourth operation 1240. Upon completion of the preset number of test cycles, the count value may be initialized to 0 in fifth operation 1250.

Unless the preset number of test cycles are not completed, it may be determined in sixth operation 1260 whether the count value does not increase due to non-detection of an abnormal battery cell during a continuous specific number of (e.g., 5) test cycles, such that a total accumulative count value may decrease by 1 in seventh operation 1270 for "Yes" and the total accumulative count value may be maintained in eighth operation 1280 for "No".

In relation to the sixth operation 1260 to the eighth operation 1280, when the abnormal battery cell is not detected during the continuous specific number of (e.g., 5) test cycles, it may mean a situation where the diagnosis target battery 120 is stabilized or a situation where the abnormal battery cell is detected for a temporary reason. Thus, through such a correction process, the accuracy of the battery diagnosis apparatus 130 may be improved.

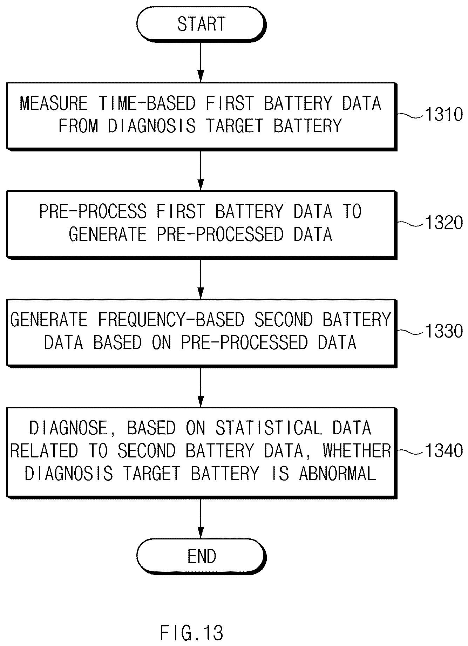

FIG. 13 illustrates operations of a battery diagnosis method according to some embodiments.

Referring to FIG. 13, a battery diagnosis method 1300 may include operations 1310 to 1340. However, without being limited thereto, some operations may be omitted and other general-purpose operations may be added, and operations of the battery diagnosis method 1300 may be executed in an order different from that shown.

The battery diagnosis method 1300 may include operations processed in time series by the battery diagnosis apparatus 130. Therefore, matters described for the battery diagnosis apparatus 130 above, even omitted below, may be equally applied to the battery diagnosis method 1300.

Operations 1310 to 1340 of the battery diagnosis method 1300 may be performed by the sensor 131 and the controller 132 of the battery diagnosis apparatus 130.

In operation 1310, the battery diagnosis apparatus 130 may measure time-based first battery data from a diagnosis target battery, through a sensor.

In operation 1320, the battery diagnosis apparatus 130 may generate pre-processed data by pre-processing the first battery data, through a controller.

In operation 1330, the battery diagnosis apparatus 130 may generate frequency-based second battery data based on the pre-processed data, through the controller.

In operation 1340, the battery diagnosis apparatus 130 may diagnose whether the diagnosis target battery is abnormal, based on statistical data related to the second battery data, through the controller.

Meanwhile, the battery diagnosis method 1300 may be implemented in the form of a computer program stored in a computer-readable storage medium. That is, the computer program may include instructions for implementing the battery diagnosis method 1300, and the instructions of the program may be stored in a computer-readable storage medium. The computer programs may include mobile applications.

For example, the computer-readable storage medium may include magnetic media such as hard disk, floppy disk, and magnetic tape, optical media such as compact disk read only memory (CD-ROM) and digital versatile disk (DVD), magneto-optical media such as floptical disk, and a hardware device especially configured to store and execute program instructions, such as read only memory (ROM), random access memory (RAM) and flash memory, etc. The computer program instructions may include a machine language code created by a complier and a high-level language code executable by a computer using an interpreter.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

The above description is merely illustrative of the technical idea of the present disclosure, and various modifications and variations will be possible without departing from the essential characteristics of embodiments of the present disclosure by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

### [Description of Symbols]

| | | | |
|---|---|---|---|
| 100: | Battery Diagnosis System | 110: | Charger/Discharger |
| 120: | Inspection Target Battery | 130: | Battery Diagnosis Apparatus |
| 131: | Sensor | 132: | Controller |
| 140: | Management Server | | |

## Claims

1. A battery diagnosis apparatus comprising:
a sensor configured to measure time-based first battery data from a diagnosis target battery; and
a controller configured to:
pre-process the first battery data to generate pre-processed data;
generate frequency-based second battery data based on the pre-processed data; and
diagnose, based on statistical data related to the second battery data, whether the diagnosis target battery is abnormal.

2. The battery diagnosis apparatus of claim 1, wherein the controller is further configured to:
calculate statistical values for amplitude values of the second battery data corresponding to battery cells of the diagnosis target battery and frequency values of the second battery data; and
diagnose, based on the statistical values, whether the diagnosis target battery is abnormal.

3. The battery diagnosis apparatus of claim 2, wherein the controller is further configured to:
calculate error values of the amplitude values based on the statistical values; and
diagnose, based on a number of error values exceeding an error reference value among the error values, whether the diagnosis target battery is abnormal.

4. The battery diagnosis apparatus of claim 3, wherein the controller is further configured to:
calculate a median value of the amplitude values for each of the frequency values to calculate median values corresponding to the frequency values; and
calculate the error values of the amplitude values based on the median value.

5. The battery diagnosis apparatus of claim 4, wherein the controller is further configured to:
calculate an average and a variance of the error values for each battery cell; and
diagnose, based on the average and the variance of the error values, whether each battery cell is abnormal.

6. The battery diagnosis apparatus of claim 5, wherein the controller is further configured to:
count a number of frequency values having an error value exceeding an error reference value, among the frequency values, for each battery cell; and
determine, as an abnormal battery cell, a battery cell in which the number of frequency values having the error value exceeding the error reference value exceeds a number reference value, among the battery cells.

7. The battery diagnosis apparatus of claim 6, wherein the controller is further configured to:
determine the abnormal battery cell for each test cycle to count a number of abnormal battery cells; and
determine, as an abnormal battery, the diagnosis target battery when the number of abnormal battery cells exceeds an abnormal battery cell reference value upon completion of a preset number of test cycles.

8. The battery diagnosis apparatus of claim 1, wherein the controller is further configured to:
perform time aggregation pre-processing on the first battery data to generate temporal uniform data; and
perform missing value imputation pre-processing on the temporal uniform data to generate the pre-processed data.

9. A battery diagnosis method comprising:
measuring time-based first battery data from a diagnosis target battery;
pre-processing the first battery data to generate pre-processed data;
generating frequency-based second battery data based on the pre-processed data; and
diagnosing, based on statistical data related to the second battery data, whether the diagnosis target battery is abnormal.

10. The battery diagnosis method of claim 9, wherein the diagnosing of whether the diagnosis target battery is abnormal comprises:
calculating statistical values for amplitude values of the second battery data corresponding to battery cells of the diagnosis target battery and frequency values of the second battery data; and
diagnosing, based on the statistical values, whether the diagnosis target battery is abnormal.

11. The battery diagnosis method of claim 10, wherein the diagnosing of whether the diagnosis target battery is abnormal comprises:
calculating error values of the amplitude values based on the statistical values; and
diagnosing, based on a number of error values exceeding an error reference value among the error values, whether the diagnosis target battery is abnormal.

12. The battery diagnosis method of claim 11, wherein the calculating of the error values comprises:
calculating a median value of the amplitude values for each of the frequency values to calculate median values corresponding to the frequency values; and
calculating the error values of the amplitude values based on the median value.

13. The battery diagnosis method of claim 12, wherein the diagnosing of whether the diagnosis target battery is abnormal comprises:
calculating an average and a variance of the error values for each battery cell; and
diagnosing, based on the average and the variance of the error values, whether each battery cell is abnormal.

14. The battery diagnosis method of claim 13, wherein the diagnosing of whether the diagnosis target battery is abnormal comprises:
counting a number of frequency values having an error value exceeding an error reference value, among the frequency values, for each battery cell; and
determining, as an abnormal battery cell, a battery cell in which the number of frequency values having the error value exceeding the error reference value exceeds a number reference value, among the battery cells.

15. The battery diagnosis method of claim 14, wherein the diagnosing of whether the diagnosis target battery is abnormal comprises:
determining the abnormal battery cell for each test cycle to count a number of abnormal battery cells; and
determining, as an abnormal battery, the diagnosis target battery when the number of abnormal battery cells exceeds an abnormal battery cell reference value upon completion of a preset number of test cycles.

16. The battery diagnosis method of claim 9, wherein the generating of the pre-processed data comprises:
performing time aggregation pre-processing on the first battery data to generate temporal uniform data; and
performing missing value imputation pre-processing on the temporal uniform data to generate the pre-processed data.

17. A battery diagnosis system comprising:
a diagnosis target battery;
a charger/discharger configured to apply test cycle voltage to the diagnosis target battery;
a battery diagnosis apparatus configured to measure time-based first battery data from the diagnosis target battery, pre-process the first battery data to generate pre-processed data, generate frequency-based second battery data based on the pre-processed data, and diagnose, based on statistical data related to the second battery data, whether the diagnosis target battery is abnormal; and
a management server configured to manage a diagnosis result for the diagnosis target battery.

18. The battery diagnosis system of claim 17, wherein the battery diagnosis apparatus is further configured to:
calculate statistical values for amplitude values of the second battery data corresponding to battery cells of the diagnosis target battery and frequency values of the second battery data; and
diagnose, based on the statistical values, whether the diagnosis target battery is abnormal.

19. The battery diagnosis system of claim 18, wherein the battery diagnosis apparatus is further configured to:
calculate error values of the amplitude values based on the statistical values; and
diagnose, based on a number of error values exceeding an error reference value among the error values, whether the diagnosis target battery is abnormal.

20. The battery diagnosis system of claim 19, wherein the battery diagnosis apparatus is further configured to:
calculate a median value of the amplitude values for each of the frequency values to calculate median values corresponding to the frequency values; and
calculate the error values of the amplitude values based on the median value.
